# EUROPEAN PATENT SPECIFICATION

(11) **EP 0 307 591 B1**
(45) Date of publication and mention of the grant of the patent: **23.03.1994**
(21) Application number: 88112127.1
(22) Date of filing: 27.07.1988
(51) Int. Cl.: H01L 21/60

(54) **Method and apparatus for aligning solder balls**
Verfahren und Vorrichtung um Lötkugeln auszurichten
Procédé et appareil pour aligner des billes de soudure

(30) Priority: 14.09.1987 JP 230406/87
(43) Date of publication of application: 22.03.1989
(73) Proprietor: HITACHI, LTD., Chiyoda-ku, Tokyo 101 (JP)
(72) Inventor: Fukasawa, Hideyuki, Hirasawa Hadano-shi (JP); Kobayashi, Mamoru, Hadano-shi (JP); Wanami, Masahiro, Hadano-shi (JP)
(74) Representative: Beetz & Partner Patentanwälte

(56) References cited:
- US-A- 3 355 078
- US-A- 4 346 516
- PATENT ABSTRACTS OF JAPAN vol. 2, no. 1 (E-001) 05 January 1978, & JP-A-52 115176
- PATENT ABSTRACTS OF JAPAN vol. 1, no. 129 (E-058) 25 October 1977, & JP-A-52 63672
- IBM TECHNICAL DISCLOSURE BULLETIN. vol. 30, no. 4, September 1987, NEW YORK US page 1755 "Release method for solder ball placement"
- IBM TECHNICAL DISCLOSURE BULLETIN. vol. 17, no. 3, August 1974, NEW YORK US page 654 R.D.AUDI ET AL: "Semiconductor chip or wafer stacking technique"

## Description

The present invention relates to an apparatus for aligning solder balls and a method using such an apparatus of the kind referred to in the preamble-portion of patent claims 1 and 5, respectively. Such an apparatus and such a method are known from JP-A-52-115176.

In a known method, a semiconductor chip is mounted on a circuit substrate, and solder balls are heated and melted to couple the electrodes of the semiconductor chip with connection pads of the circuit substrate electrically and mechanically. In implementing this method, it becomes necessary to align and stick onto electrodes of the semiconductor chip or connection pads of the circuit substrate.

Such alignment of solder balls has heretofore been performed as follows. First of all, a mask having a number of holes corresponding to aligned positions of the solder balls is placed on the electrode face of the semiconductor chip or the component mounting face of the circuit substrate, and solder balls are supplied onto the mask. Under this state, the mask is vibrated to put solder balls into holes of the mask, or solder balls are put into holes manually one by one by using a tool such as a vacuum pincette or a brush. Thereafter extra solder balls existing on the mask are removed by using a brush, for example.

Such a method is described in JP-A-58-35935, for example.

JP-A-52-115176 discloses an apparatus for aligning solder balls comprising an aligning plate having aligned through-holes formed therein, supplied solder balls being aligned by said aligning plate; an aligning plate fixing block for fixing said aligning plate; and an air sucking nozzle coupled to said aligning plate fixing block.

Further this document shows a method for aligning solder balls comprising the steps of supplying solder balls onto an aligning plate having aligned through-holes formed therein; and sucking air from the bottom of said aligning plate to fit and attract solder balls into said through-holes and align the solder balls.

Further, US-A-3 355 078 discloses a positioning of the electrical components which is performed by the groove having the same form as the external form of the electrical component, and the fixation of the electrical component is performed by sucking. The groove is used only for positioning of electrical components. It is not used for preventing the mutual fusion of the electrical components and/or eliminating extra electrical components. Therefore this document discloses nothing except the positioning and the fixation of the electrical components.

US-A-43 46 516 shows a method of forming a ceramic circuit substrate according to which a device is used for embedding metallic balls into the green sheet of said substrate.

In the above described prior art, solder balls might adhere to each other and solder balls might adhere to a tool such as a brush because of static electricity. Therefore, solder balls might not get easily into holes of the mask and solder balls aligned once might jump out from holes when extra solder balls on the mask are removed, resulting in a problem of extremely low work efficiency.

An object of the present invention is to provide an efficient apparatus for aligning solder balls with the above described problem.

The above described object is accomplished with an apparatus and a method using said apparatus as claimed in claims 1 and 5, respectively. Dependent claims are directed on features of preferred embodiments of the invention.

Since solder balls supplied onto the aligning plate are attracted into through-holes of the aligning plate by air, it is possible to align solder balls on the aligning plate sufficiently without being affected by static electricity. Since solder balls aligned once are attracted into through-holes of the aligning plate, solder balls already aligned do not jump out from the through-holes when extra solder balls are removed by a brush or the like. Therefore, efficient aligning work becomes possible.

### BRIEF DESCRIPTION OF THE DRAWINGS

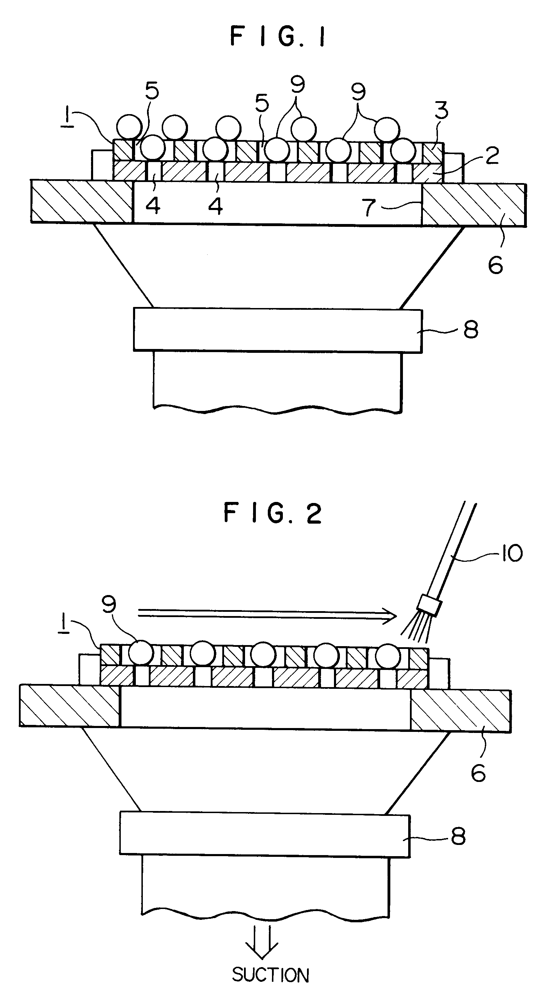

Figs. 1 and 2 are rough sectional views used for explaining an embodiment of the present invention.

Fig. 1 is a sectional view showing solder balls aligned by air suction.

Fig. 2 is a sectional view showing work of removing extra balls.

Fig. 3 shows a semiconductor chip placed on an aligning plate.

### DESCRIPTION OF THE PREFERRED EMBODIMENTS

An embodiment of the present invention will now be described by referring to Figs. 1 and 2.

In Figs. 1 and 2, numeral 1 denotes an alignment plate, which is formed by sticking two plates, i.e., a lower plate 2 and an upper plate 3 together. The material of the plates 2 and 3 comprises glass or ceramics, for example. In case of glass, photosensitive glass having excellent working performance, heat-resistance and adaptability in the rate of expansion with semiconductor chip, for example, is often used.

In the lower plate 2, through-holes 4 having smaller diameters than outer diameters of solder balls to be aligned are opened at positions corresponding to alignment positions. In the upper plate 3, through-holes 5 having slightly larger diameters than outside diameters of solder balls are opened at positions corresponding to the through-holes 4.

Numeral 6 denotes an aligning plate fixing block for fixing the aligning plate 1. An air sucking nozzle 8 is coupled to the aligning plate fixing block 6 so as to face an opening 7 of the aligning plate fixing block. The air sucking nozzle 8 is connected to a vacuum pump or the like, which is not illustrated, via a tube or the like.

When solder balls are to be aligned, the aligning plate 1 is fixed to the aligning plate fixing block 6 and solder balls 9 are supplied onto the aligning plate 1.

Air suction using the sucking nozzle 8 is then started. Since air on the surface of the aligning plate 1 is sucked via the through-holes 4 and 5, solder balls 9 located near through-holes 5 are attracted into the through-holes together with air and eventually attracted and held under the state that they are fitted into the through-holes 5. That is to say, the through-holes 5 serve as guide holes for attracting solder balls 9, while the lower throughholes 4 actually position and attract the solder balls.

After solder balls 9 are aligned at all through-hole positions, the surface of the aligning plate 1 is swept by a brush 10 as shown in Fig. 2, for example, to remove extra solder balls existing on the aligning plate 1. Since solder balls already aligned are held in the through-holes 4 by the air suction during this work, solder balls already aligned do not jump out from the through-holes 4. The fact that only upper portions of the aligned solder balls protrude slightly from the surface of the aligning plate 1 and most portions of the aligned solder balls are within the through-holes 5 is also effective in preventing the escape of the solder balls already aligned.

After such work has been performed, the air suction is stopped, and the aligning plate 1 for aligning the solder balls is removed from the aligning plate fixing block 6. The work for aligning the solder balls is thus completed.

If a shock is applied to the aligning plate 1 or the aligning plate 1 is tilted during the work of removing the aligning plate fixing block or thereafter, there is a possibility that solder balls slip out from the through-holes 4. Since the solder balls are held in the through-holes 5, however, the solder balls easily return to the through-holes 4. The through-holes 5 perform such function as well.

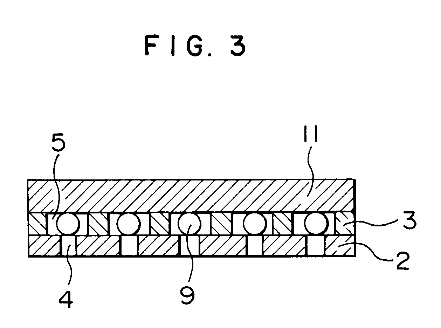

After the work of aligning the solder balls has been finished, the aligning plates 2 and 3 are removed from the aligning plate fixing block 6, and a circuit substrate 11 is placed on the aligning plates 2 and 3 to perform soldering work, as shown in Fig. 3.

Although an embodiment has heretofore been described, the present invention may be modified to be executed as occasion demands.

For example, solder balls are supplied onto the aligning plate under the state that the air suction is stopped in the above described embodiment. However, solder balls may be supplied while the air suction is being performed. The structure of the aligning plate may be changed suitably. For example, two plates of the aligning plate 1, i.e., the lower plate 2 and the upper plate 3 may be formed as one body.

Further, the method of the present invention is similarly applicable to alignment of small balls other than solder balls.

As evident from the foregoing description, the present invention brings about an effect that solder balls can be aligned easily and efficiently.

## Claims

1. An apparatus for aligning solder balls comprising:
an aligning plate (1) having aligned through-holes (4, 5) formed therein, supplied solder balls being aligned by said aligning plate;
an aligning plate fixing block (6) for fixing said aligning plate; and
an air sucking nozzle (8) coupled to said aligning plate fixing block, characterized in that said aligning plate comprises two plates
comprising a lower plate (2) and an upper plate (3);
through-holes (4) having smaller diameters than outer diameters of solder balls to be aligned are opened at positions of said lower plate corresponding to alignment positions; and
through-holes (5) having slightly larger diameters than outer diameters of solder balls are opened at positions of said upper plate corresponding to said through-holes (4) opened in said lower plate.

2. An apparatus for aligning solder balls according to Claim 1,wherein two plates comprising the lower plate (2) and the upper plate (3) constituting the aligning plate comprise glass.

3. An apparatus for aligning solder balls according to Claim 1, wherein two plates comprising the lower plate (2) and the upper plate (3) constituting the aligning plate comprise photosensitive glass.

4. An apparatus for aligning solder balls according to Claim 1, wherein two plates comprising the lower plate (2) and the upper plate (3) constituting the aligning plate comprise ceramics.

5. A method for aligning solder balls using an apparatus according to one of claims 1 to 4, comprising the steps of:
supplying solder balls (9) onto an aligning plate (1) having aligned through-holes (4, 5) formed therein; and
sucking air from the bottom of said aligning plate to fit and attract solder balls into said through-holes and align the solder balls,
characterized in that
said aligning plate comprises two plates comprising a lower plate (2) and an upper plate (3), through-holes (4) having smaller diameters than outer diameters of solder balls to be aligned being opened at positions of said lower plate corresponding to alignment positions, through holes (5) having slightly larger diameters than outer diameters of solder balls being opened at positions of said upper plate corresponding to said through-holes (4) opened in said lower plate;
said aligning plate is fixed to an aligning plate fixing block (6), said alignment plate fixing plate being coupled to an air sucking nozzle (8); and
said method comprises the steps of:
supplying solder balls onto said aligning plate;
sucking air by using said sucking nozzle;
attracting and fitting solder balls existing on said aligning plate into through-holes (5) having slightly larger diameters than outer diameters of the solder balls; and
positioning and attracting solder balls into through-holes (4) having smaller diameters than outer diameters of solder balls to align the solder balls.

6. A method for aligning solder balls according to Claim 5, wherein said aligning plate comprises glass.

7. A method for aligning solder balls according to Claim 5, wherein said aligning plate comprises photosensitive glass.

8. A method for aligning solder balls according to Claim 5, wherein said aligning plate comprises ceramics.

## Patentansprüche

1. Vorrichtung zum Ausrichten von Lötkugeln mit
einer Ausrichtplatte (1) mit darin ausgebildeten durchgehenden Ausrichtlöchern (4, 5), wobei aufgebrachte Lötkugeln durch diese Ausrichtplatte ausgerichtet werden;
einem Ausrichtplatten-Fixierblock (6) zum Fixieren der Ausrichtplatte; und
einer Luftansaugdüse (8), die mit dem Ausrichtplatten-Fixierblock (6) verbunden ist,
dadurch gekennzeichnet, daß
die Ausrichtplatte zwei Platten enthält, die eine untere Platte (2) und eine obere Platte (3) umfassen;
Durchgangslöcher (4) mit kleineren Durchmessern als die Außendurchmesser der auszurichtenden Lötkugeln an Stellen der unteren Platte geöffnet sind, die den Ausrichtpositionen entsprechen; und
die Durchgangslöcher (5) etwas größere Durchmesser als die Außendurchmesser der Lötkugeln aufweisen und an Stellen der oberen Platte geöffnet sind, die den in der unteren Platte geöffneten Durchgangslöchern (4) entsprechen.

2. Vorrichtung zum Ausrichten von Lötkugeln nach Anspruch 1, bei der die beiden Platten, nämlich die untere Platte (2) und die obere Platte (3), die die Ausrichtplatte bilden, Glas enthalten.

3. Vorrichtung zum Ausrichten von Lötkugeln nach Anspruch 1, bei der die beiden Platten, nämlich die untere Platte (2) und die obere Platte (3), die die Ausrichtplatte bilden, photosensitives Glas enthalten.

4. Vorrichtung zum Ausrichten von Lötkugeln nach Anspruch 1, bei der die beiden Platten, nämlich die untere Platte (2) und die obere Platte (3), die die Ausrichtplatte bilden, Keramik enthalten.

5. Verfahren zum Ausrichten von Lötkugeln unter Verwendung einer Vorrichtung nach einem der Ansprüche 1 bis 4, die folgende Schritte umfaßt:
Aufbringen von Lötkugeln (9) auf eine Ausrichtplatte (1) mit darin ausgebildeten ausgerichteten Durchgangslöchern (4, 5); und
Ansaugen von Luft von der Unterseite der Ausrichtplatte, um Lötkugeln in die Durchgangslöcher einzupassen und anzuziehen und die Lötkugeln auszurichten,
dadurch gekennzeichnet, daß
die Ausrichtplatte (1) zwei Platten enthält, die eine untere Platte (2) und eine obere Platte (3) umfassen, Durchgangslöcher (4) mit kleineren Durchmessern als die Außendurchmesser der auszurichtenden Lötkugeln an Stellen der unteren Platte geöffnet sind, die den Ausrichtpositionen entsprechen, und Durchgangslöcher (5) mit etwas größeren Durchmessern als die Außendurchmesser der Lötkugeln an Stellen der oberen Platte geöffnet sind, die den in der unteren Platte geöffneten Durchgangslöchern (4) entsprechen;
die Ausrichtplatte (1) an einem Ausrichtplatten-Fixierblock (6) befestigt ist, wobei der Ausrichtplatten-Fixierblock mit einer Luftansaugdüse (8) verbunden ist; und
das Verfahren folgende Schritte umfaßt:
Aufbringen von Lötkugeln auf die Ausrichtplatte;
Ansaugen von Luft unter Verwendung der Luftansaugdüse;
Anziehen und Einpassen von auf der Ausrichtplatte befindlichen Lötkugeln in die Durchgangslöcher (5) mit etwas größeren Durchmessern als die Außendurchmesser der Lötkugeln; und
Positionieren und Anziehen von Lötkugeln in die Durchgangslöcher (4) mit kleineren Durchmessern als die Außendurchmesser der Lötkugeln.

6. Verfahren zum Ausrichten von Lötkugeln nach Anspruch 5, bei dem die Ausrichtplatte Glas enthält.

7. Verfahren zum Ausrichten von Lötkugeln nach Anspruch 5, bei dem die Ausrichtplatte photosensitives Glas enthält.

8. Verfahren zum Ausrichten von Lötkugeln nach Anspruch 5, bei dem die Ausrichtplatte Keramik enthält.

## Revendications

1. Dispositif pour aligner des billes de soudure comprenant :
une plaque d'alignement (1) possédant des trous traversants alignés (4, 5) ménagés en elle et recevant des billes de soudure qui sont alignées par ladite plaque d'alignement;
un bloc (6) de fixation de la plaque d'alignement pour fixer ladite plaque d'alignement; et
une buse d'aspiration d'air (8) couplée audit bloc de fixation de la plaque d'alignement,
caractérisé en ce que ladite plaque d'alignement comporte deux plaques
comprenant une plaque inférieure (2) et une plaque supérieure (3);
des trous traversants (4) possédant des diamètres inférieurs à des diamètres extérieurs de billes de soudure devant être alignées débouchent dans des positions de ladite plaque inférieure, qui correspondent à des positions d'alignement; et
des trous traversants (5) possédant des diamètres légèrement supérieurs à des diamètres extérieurs de billes de soudure débouchent dans des positions de ladite plaque supérieure, qui correspondent auxdits trous traversants (4) débouchant dans ladite plaque inférieure;

2. Dispositif pour aligner des billes de soudure selon la revendication 1, dans lequel deux plaques comprenant la plaque inférieure (2) et la plaque supérieure (3) constituant la plaque d'alignement sont réalisées en verre.

3. Dispositif pour aligner des billes de soudure selon la revendication 1, dans lequel deux plaques comprenant la plaque inférieure (2) et la plaque supérieure (3) constituant la plaque d'alignement sont réalisées en verre photosensible.

4. Dispositif pour aligner des billes de soudure selon la revendication 1, dans lequel deux plaques comprenant la plaque inférieure (2) et la plaque supérieure (3) constituant la plaque d'alignement sont réalisées en céramique.

5. Procédé pour aligner des billes de soudure moyennant l'utilisation d'un dispositif selon l'une des revendications 1 à 4, comprenant les étapes consistant à :
amener des billes de soudure (9) sur une plaque d'alignement (1) possédant des trous traversants alignés (4, 5) ménagés en elle; et
aspirer de l'air à partir du dessous de ladite plaque d'alignement pour insérer et attirer des billes de soudure dans lesdits trous traversants et aligner les billes de soudure,
caractérisé en ce que
ladite plaque d'alignement comporte deux plaques comprenant une plaque inférieure (2) et une plaque supérieure (3), des trous traversants (4) possédant des diamètres inférieurs à des diamètres extérieurs de billes de soudure devant être alignées et qui débouchent dans des positions de ladite plaque inférieure qui correspondent à des positions d'alignement, des trous traversants (5) possédant des diamètres légèrement supérieurs à des diamètres extérieurs de billes de soudure et qui débouchent dans des positions de ladite plaque supérieure, qui correspondent auxdits trous traversants (4)débouchant dans ladite plaque inférieure;
ladite plaque d'alignement est fixée à un bloc (6) de fixation de la plaque d'alignement, ledit bloc de fixation de la plaque d'alignement étant couplé à une buse d'aspiration d'air (8); et
ledit procédé comprend les étapes consistant à :
amener des billes de soudure sur ladite plaque d'alignement;
aspirer de l'air en utilisant ladite buse d'aspiration;
attirer et fixer des billes de soudure existant sur ladite plaque d'alignement dans des trous traversants (5) possédant des diamètres légèrement supérieurs à des diamètres extérieurs des billes de soudure; et
positionner et attirer des billes de soudure dans des trous traversants (4) possédant des diamètres inférieurs à des diamètres extérieurs de billes de soudure pour aligner les billes de soudure.

6. Procédé pour aligner des billes de soudure selon la revendication 5, selon lequel ladite plaque d'alignement est réalisée en verre.

7. Procédé pour aligner des billes de soudure selon la revendication 5, selon lequel ladite plaque d'alignement est réalisée en verre photosensible.

8. Procédé pour aligner des billes de soudure selon la revendication 5, selon lequel ladite plaque d'alignement est réalisée en céramique.
